# FASCICULE DE BREVET EUROPEEN

(11) **EP 3 035 386 B1**
(45) Date de publication et mention de la délivrance du brevet: **27.04.2022**
(21) Numéro de dépôt: 15200831.4
(22) Date de dépôt: 17.12.2015
(51) Int. Cl.: H01L 27/12, H01L 29/786, H01L 29/417, H01L 29/66

(54) **PROCÉDÉ DE RÉALISATION D'UN DISPOSITIF À EFFET DE CHAMP AMÉLIORÉ**
HERSTELLUNGSVERFAHREN EINER VERBESSERTEN FELDEFFEKTVORRICHTUNG
METHOD FOR PRODUCING AN IMPROVED FIELD EFFECT DEVICE

(30) Priorité: 17.12.2014 FR 1462602
(43) Date de publication de la demande: 22.06.2016
(73) Titulaire: Commissariat à l'Energie Atomique et aux Energies Alternatives, 75015 Paris (FR)
(72) Inventeur: Previtali, Bernard, 38100 Grenoble (FR)
(74) Mandataire: Talbot, Alexandre

(56) Documents cités:
- EP-A2- 2 562 802
- US-A1- 2006 027 881
- US-A1- 2011 115 022
- US-A1- 2011 241 073
- LA TULIPE D C ET AL: "Upside-down FETS", 2008 IEEE INTERNATIONAL SOI CONFERENCE PROCEEDINGS, PISCATAWAY, NJ, USA, 6 octobre 2008 (2008-10-06), pages 23-24, XP031351836, ISBN: 978-1-4244-1954-8
- SKOTNICKI T: "SILICON ON NOTHING (SON) - FABRICATION, MATERIAL AND DEVICES", PROCEEDINGS - ELECTROCHEMICAL SOCIETY, ELECTROCHEMICAL SOCIETY, PENNINGTON, NJ, US, vol. 2001, no. 3, 25 mars 2001 (2001-03-25), pages 391-402, XP008014133, ISSN: 0161-6374

## Description

### Domaine technique de l'invention

L'invention est relative à un procédé de réalisation d'un dispositif à effet de champ.

### État de la technique

L'augmentation continue des performances des circuits intégrés, par exemple, en termes de consommation et/ou de fréquence de fonctionnement, se traduit inéluctablement par une diminution constante de la taille de ses composants. Afin de réaliser des dispositifs toujours plus performants, de nouvelles architectures et/ou de nouveaux matériaux ont été intégrés dans les transistors.

Cependant, il apparaît que pour de nombreuses architectures, les capacités parasites prennent une place de plus en plus importante ce qui réduit les gains procurés par les autres améliorations. Une manière de réduire ces capacités parasites est de placer les contacts de source et de drain d'un côté du film en matériau semi-conducteur formant le canal de conduction et les zones de source/drain. L'électrode de grille est disposée de l'autre côté du film semi-conducteur ce qui réduit fortement la surface en regard entre l'électrode de grille est les contacts. Un exemple de réalisation est décrit dans le brevet US7915110. Cependant, il s'avère que ce procédé de fabrication est compliqué à réaliser car il nécessite d'amorphiser les futures zones de source et de drain et d'utiliser la différence de propriété optique entre les zones amorphes et les zones cristallines pour placer correctement des masques de protection.

Le document US 2013/0299897 décrit la réalisation d'un transistor inversé avec prise des contacts de source et de drain sur la face opposée à l'électrode de grille. Une électrode de grille est réalisée sur un substrat de type semi-conducteur sur isolant.

L'électrode de grille sert de masque de gravure pour graver la couche de semi-conducteur sur isolant, la couche d'isolant enterré puis une partie du substrat de support semi-conducteur.

Une épitaxie est réalisée à partir du substrat pour venir connecter le substrat de support avec la couche de semi-conducteur sur isolant. Les zones épitaxiées forment les zones de source et de drain. Un encapsulant est déposé et est collé à un deuxième substrat de support.

Le premier substrat de support est éliminé pour accéder à la couche d'isolant enterré et aux zones de source et de drain formées par épitaxie. Un nouvel encapsulant est déposé puis gravé pour former des contacts de source et de drain.

Ce document enseigne également de réaliser une deuxième électrode de grille en utilisant l'isolant enterré comme diélectrique de grille.

A la lecture de ce document on s'aperçoit aisément que la réalisation d'un tel dispositif est très difficile et que le dispositif final ne sera pas aussi performant qu'attendu.

Le document US 2011/115022 décrit la réalisation d'un transistor dont le canal de conduction est disposé sur une couche électriquement isolante. La couche électriquement isolante est formée par dépôt d'un matériau électriquement isolant à l'intérieur d'une cavité réalisée par gravure sélective d'une couche en SiGe. Une fois le transistor formé, les zones de source et drain sont siliciurées. Une couche isolante est déposée puis des trous de contact sont formés pour accéder aux zones de source, de drain et de grille.

La publication de D.C. La Tulipe Jr et al. ("Upside-Down FETs", 2008 IEEE International SOI Conférence Proceedings, 6 octobre 2008, pages 23-24) présente la réalisation d'une architecture 65nm conventionnelle dans laquelle après l'étape de siliciuration et le dépôt d'une couche diélectrique contrainte. Ensuite, une couche d'oxyde PECVD est déposée pour coller les transistors sur un nouveau substrat de support. Le substrat de support initial est supprimé et des trous de contact sont formés pour accéder aux zones de source, de drain et de grille.

### Objet de l'invention

L'invention a pour objet la réalisation d'un dispositif à effet de champ qui présente des performances électriques améliorées et qui est plus facile à mettre en œuvre.

Le procédé selon l'invention est décrit dans les revendications annexées et est remarquable en ce qu'il comporte successivement :
- prévoir un substrat recouvert par
   ∘ un motif en matériau semi-conducteur comportant une première couche en premier matériau semi-conducteur recouvrant une deuxième couche en deuxième matériau semi-conducteur,
   ∘ un motif de grille recouvrant le motif en matériau semi-conducteur de manière à définir une zone de source, une zone de drain et un canal de conduction dans le motif en matériau semi-conducteur,
- graver la première couche en premier matériau semi-conducteur en utilisant le motif de grille comme masque de gravure,
- graver la deuxième couche en deuxième matériau semi-conducteur de manière à former une cavité et suspendre la première couche en premier matériau semi-conducteur,
- déposer un matériau de remplissage de manière à remplir la cavité,
- graver le matériau de remplissage en utilisant le motif de grille comme masque de gravure pour former un motif de partage dans la cavité, le motif en matériau semi-conducteur recouvrant le motif de partage, le motif de partage comportant au moins trois faces consécutives recouvertes par le motif en matériau semi-conducteur,
- former les zones de source et de drain par épitaxie sélective,
- déposer une couche de couverture de manière à recouvrir le substrat, le motif en matériau semi-conducteur et le motif de grille,
- éliminer le substrat de manière à libérer une partie de la zone de source, de la zone de drain et du motif de grille,
- déposer une deuxième couche de couverture, les première et deuxième couches de couverture étant séparées par le motif en matériau semi-conducteur sur au moins une partie,
- former des trous d'accès à la zone de source, à la zone de drain et au motif de grille dans la deuxième couche de couverture,
- remplir les trous d'accès par un conducteur électrique de manière à former des contacts de source et de drain disposés d'une coté du canal de conduction et une électrode de grille majoritairement disposée de l'autre coté du canal de conduction.

Dans un mode de réalisation particulier le substrat comporte une troisième couche en troisième matériau semi-conducteur différent du deuxième matériau semi-conducteur, la troisième couche étant disposée sous la deuxième couche pour faciliter la formation des zones de source et de drain.

De manière encore plus avantageuse, pour faciliter la gravure de la deuxième couche, il est avantageux de prévoir que le premier matériau semi-conducteur est identique au troisième matériau semi-conducteur.

Pour faciliter la formation des zones de source et de drain, les gravures de la deuxième couche et du matériau de remplissage sont configurées pour sauvegarder au moins une partie de la troisième couche de manière à permettre la formation des zones de source et de drain depuis la troisième couche lors de l'étape d'épitaxie sélective

Il est également avantageux de prévoir que le motif de grille est utilisé comme masque de gravure pour graver la première couche et la deuxième couche de sorte que la troisième couche comporte une zone partiellement découverte par la deuxième couche et en ce que les zones de source et de drain sont formées par épitaxie à partir de la zone partiellement découverte.

Dans un cas particulier, la gravure du matériau de remplissage est réalisée en utilisant le motif de grille en tant que masque de gravure de sorte que la troisième couche soit partiellement recouverte par le matériau de remplissage formant le motif de partage.

Dans un mode de réalisation, le substrat est un substrat de type silicium sur isolant et le procédé comporte une étape de condensation du germanium pour former la deuxième couche ou une troisième couche en alliage de silicium-germanium.

Il est avantageux d'utiliser une quatrième couche en quatrième matériau semi-conducteur différent du troisième semi-conducteur, la quatrième couche étant disposée sous la troisième couche.

Il est envisageable de prévoir que le substrat est de type silicium sur isolant et que la première couche est en alliage de silicium-germanium.

Le motif de partage peut être réalisé dans un matériau électriquement isolant dans un procédé qui comporte, après élimination du substrat, le dépôt d'un matériau métallique et son recuit pour former un alliage entre le matériau métallique et un matériau semi-conducteur.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

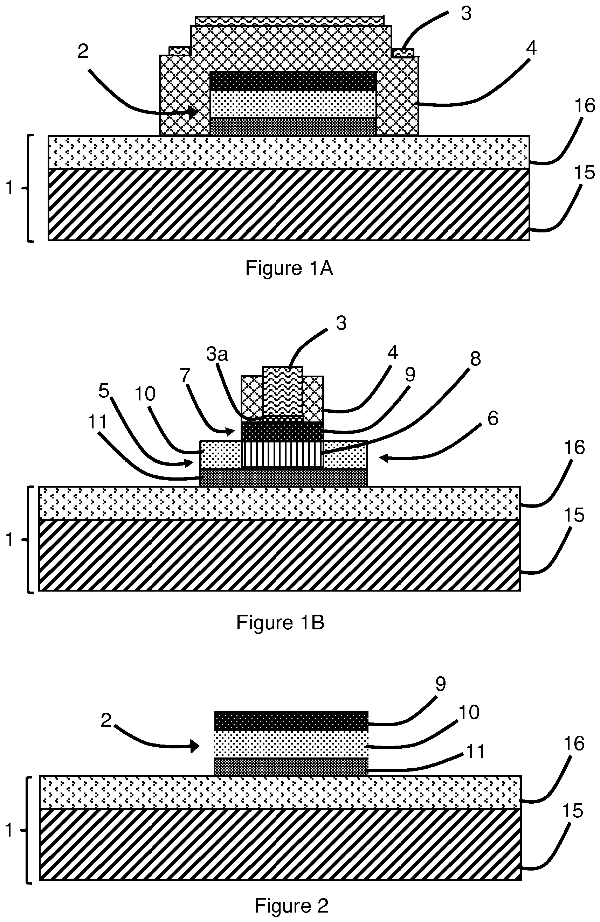

- les figures 1 à 10 représentent, de manière schématique, en vue de coupe des étapes successives d'un procédé de réalisation d'un transistor à effet de champ.

Les figures A représentent une coupe selon un axe longitudinal de l'électrode de grille. Les figures B représentent une coupe selon un axe transversal de l'électrode de grille.

### Description de modes de réalisation préférentiels de l'invention

Comme illustré à la figure 1, le procédé de réalisation du dispositif à effet de champ comporte en premier lieu la fourniture d'un substrat 1 dont une face est recouverte par un motif en matériau semi-conducteur 2. Le motif en matériau semi-conducteur 2 est partiellement recouvert par un motif de grille 3. Le motif en matériau semi-conducteur 2 peut également être recouvert par un espaceur latéral 4. Dans le mode de réalisation illustré, le motif en matériau semi-conducteur 2 est en saillie du substrat 1. La figure 1A représente une coupe selon un axe longitudinal du motif de grille. La figure 1B représente une coupe selon un axe transversal du motif de grille.

Le motif de grille 3 définit, à l'intérieur du motif en matériau semi-conducteur 2, une zone de source 5, une zone de drain 6 et un canal de conduction qui relie les zones de source 5 et de drain 6. Le canal de conduction est disposé sous le motif de grille 3.

Le motif en matériau semi-conducteur 2 peut comporter une zone en saillie également appelée zone de conduction 7 qui se trouve sous le motif de grille 3 et entre les futures zones de source 5 et de drain 6. La zone de conduction 7 est en matériau semi-conducteur. Il est également envisageable d'avoir un film continu qui forme le canal de conduction et les zones de source et de drain 5 et 6. Dans cette configuration, la zone de conduction 7 n'est pas obligatoirement en saillie par rapport aux zones de source et de drain. Le canal de conduction correspond sensiblement ou exactement au futur canal de conduction.

Le film semi-conducteur de la figure 1B peut déborder de chaque côté de manière à s'étendre au delà du motif de grille 3.

Le motif en matériau semi-conducteur 2 recouvre ou enrobe un motif de partage 8 qui est disposé sous l'électrode de grille 3 et plus précisément sous la zone de conduction 7 de sorte que les zones de source 5 et de drain 6 sont séparées par le motif de partage 8 sur au moins une partie de leur épaisseur. Le motif de partage 8 comporte au moins trois faces consécutives recouvertes par le motif en matériau semi-conducteur 2.

Dans un mode de réalisation particulier, le motif en matériau semi-conducteur 2 est formé par un empilement d'au moins une première couche 9 en premier matériau semi-conducteur recouvrant une deuxième couche 10 en deuxième matériau semi-conducteur. Les deux matériaux semiconducteurs 9 et 10 sont différents. De manière avantageuse, les première et deuxième couches sont monocristallines et préférentiellement en accord de maille. La première couche 9 est par exemple en silicium et la deuxième couche 10 est en alliage de silicium-germanium, préférentiellement un alliage contenant 30% de germanium, de préférence 30% atomique. Dans une variante de réalisation, la première couche 9 est en alliage de silicium-germanium, par exemple un alliage contenant 30% de germanium, de préférence 30% atomique et la deuxième couche 10 est en silicium.

Dans un mode de réalisation encore plus avantageux illustré aux figures 1A, 1B et 2, la deuxième couche 10 en deuxième matériau semi-conducteur recouvre une troisième couche 11 en troisième matériau semi-conducteur. Le deuxième matériau semi-conducteur est différent du troisième matériau semi-conducteur. Le premier matériau semi-conducteur peut être identique au troisième matériau semi-conducteur. Avantageusement, les trois couches 9, 10 et 11 sont monocristallines et préférentiellement en accord de maille.

Les première et troisième couches 9 et 11 sont par exemple en silicium et la deuxième couche 10 est en alliage de silicium-germanium, préférentiellement un alliage contenant 30% de germanium, de préférence 30% atomique.

En variante, Les première et troisième couches 9 et 11 sont par exemple en alliage de silicium-germanium, préférentiellement un alliage contenant 30% de germanium, de préférence 30% atomique et la deuxième couche 10 est en silicium.

Il est avantageux d'utiliser un substrat de type semi-conducteur sur isolant où la couche en matériau semi-conducteur est la couche 10 ou la couche 11 selon le nombre de couches utilisées dans l'empilement. Le substrat peut donc être de type silicium sur isolant ou alors silicium-germanium sur isolant.

Il est également possible de former la couche inférieure de l'empilement, c'est-à-dire la couche 10 ou la couche 11 à partir d'une étape de condensation de germanium. Par exemple, le substrat initial est de type silicium sur isolant et une couche de silicium-germanium est déposée. Au moyen de l'étape de condensation du germanium, la couche de silicium est transformée en une couche de silicium-germanium voire en une couche de germanium pur. Il est ensuite possible de déposer par épitaxie une couche de silicium.

Dans une autre variante de réalisation, le substrat est de type silicium sur isolant et un empilement de quatre couches est formé de manière à définir des futurs canaux en alliage de silicium-germanium. La quatrième couche 11' en quatrième matériau semi-conducteur est recouverte par la troisième couche 11. Les matériaux des troisième et quatrième couches sont différents.

La quatrième couche 11' permet d'utiliser un substrat de type silicium sur isolant tout en formant un futur canal en alliage de silicium-germanium. La couche 11' de silicium est alors recouverte par une couche 11 d'alliage de silicium-germanium puis par une couche 10 de silicium et enfin par une couche 9 d'alliage de silicium-germanium. L'utilisation d'un empilement à quatre couches permet de faciliter la future étape d'épitaxie pour former les zones de source et de drain à partir de la couche 11 qui est ici en alliage de silicium-germanium.

Cette structure avantageuse peut être réalisée simplement au moyen du procédé qui va suivre.

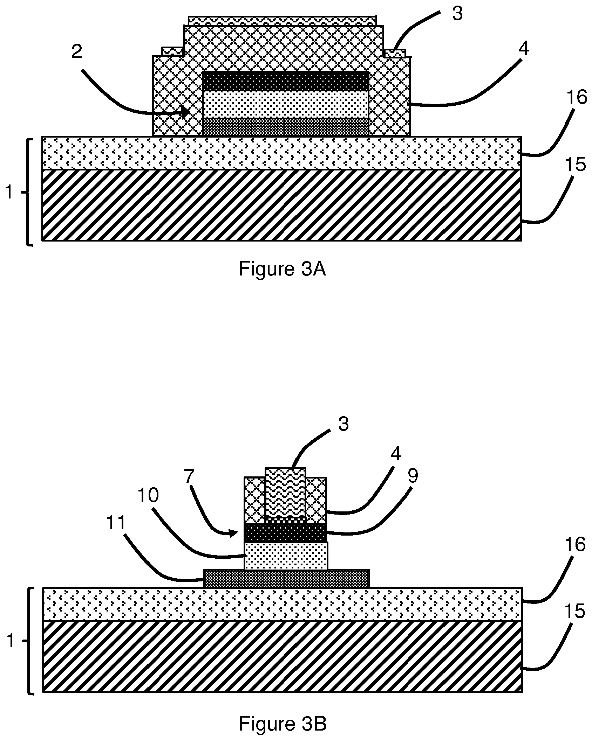

De manière avantageuse illustrée aux figures 3A et 3B, le motif de grille 3 et l'espaceur latéral 4 sont formés sur le motif 2 et sont utilisés pour servir de masque de gravure à la première couche 9 et à la deuxième couche 10. La zone gravée dans la première couche 9 forme la zone de conduction 7 qui est représentative du canal de conduction. La gravure est avantageusement anisotrope afin de définir une zone de conduction 7 qui présente les mêmes dimensions latérales ou sensiblement les mêmes dimensions latérales que l'électrode de grille 3 et l'espaceur latéral 4. L'espaceur latéral 4 peut être formé par une ou plusieurs couches. Il est particulièrement avantageux d'avoir un motif de grille 3 qui déborde sur les deux bords opposés du motif 2.

Dans un empilement à trois ou quatre couches, il est avantageux de ne pas structurer la troisième couche ni la quatrième couche 11' afin qu'elle déborde au delà du motif formé par la couche 10.

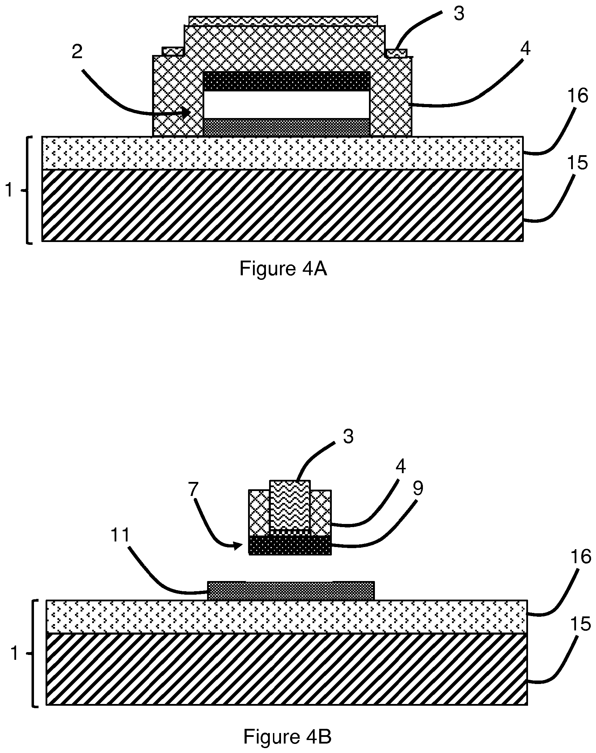

Comme illustré aux figures 4A et 4B, la seconde couche 10 est ensuite éliminée, par toute technique adaptée. La gravure peut être réalisée par voie humide ou par voie sèche. La première couche 9 est alors suspendue au-dessus du substrat 1. La première couche 9 est maintenue au moyen du motif de grille 3 et/ou de l'espaceur latéral 4. La gravure de la seconde couche 10 est avantageusement une gravure isotrope. La gravure de la seconde couche 10 forme une cavité sous la couche 9.

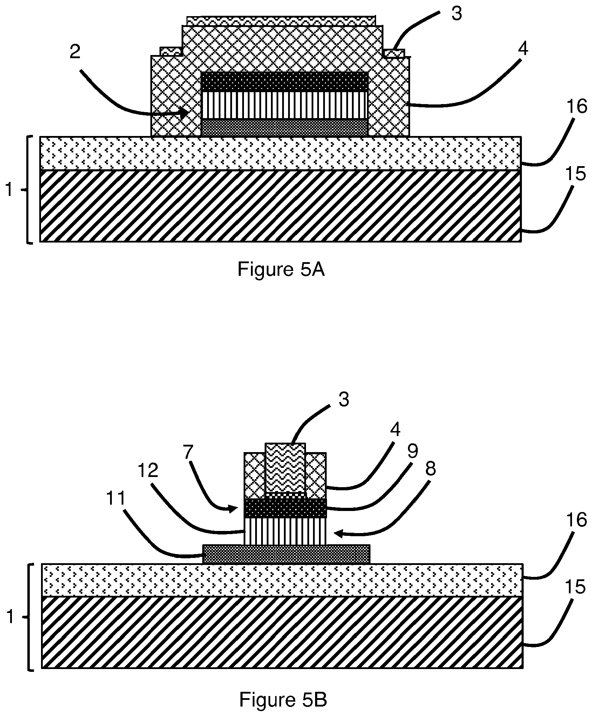

Comme illustré aux figures 5A et 5B, un matériau de remplissage 12 est déposé et gravé de manière à remplir la cavité disposée sous la première couche 9 dans le prolongement du motif de grille 3 et éventuellement de l'espaceur latéral 4. De cette manière, le motif de conduction 7 et le matériau de remplissage 12 formant le motif de partage 8 présentent des parois latérales alignées qui forment les parois du motif 2.

De manière avantageuse, le matériau de remplissage 12 est déposé de manière conforme pour remplir complètement la cavité. Le motif de grille 3 et l'espaceur latéral 4 sont de nouveau utilisés pour réaliser un masque de gravure qui vient localiser le matériau de remplissage 12 uniquement sous la première couche 9. Le motif en matériau de remplissage 12 vient former le motif de partage 8. Le matériau de remplissage 12 est par exemple un oxyde de silicium et plus particulièrement un oxyde déposé à haute température. L'épaisseur de matériau de remplissage 12 est avantageusement supérieure à la moitié de l'épaisseur de la deuxième couche 10 ou de la hauteur de la cavité qui existe sous la première couche 9.

En variante, un autre matériau de remplissage peut être déposé comme un nitrure de silicium ou un empilement de plusieurs couches. Il est également envisageable de prévoir une oxydation de la première couche 9 pour remplir la cavité. Dans ce dernier cas de figure, l'épaisseur et la largeur de la première couche 9 sont choisies en conséquence et une désoxydation des flancs de la première couche 9 est réalisée pour autoriser une future étape d'épitaxie. Si une couche 11 est utilisée, cette dernière peut être oxydée.

Il est également possible de prévoir le remplissage de la cavité par plusieurs couches dont au moins une des couches est contrainte en tension ou en compression de manière à appliquer des contraintes sur le canal de conduction. De manière avantageuse, pour un transistor de type Nmos, l'empilement de couches comporte au moins une couche en nitrure de silicium contrainte en tension. Pour un transistor de type Pmos, l'empilement de couches comporte au moins une couche en nitrure de silicium contrainte en compression.

Cette architecture est particulièrement avantageuse car elle permet de localiser le canal de conduction sous le motif de grille 3 et de la même manière de localiser le motif de partage 8 sous le motif de grille. Les espaceurs 4 peuvent être utilisés pour définir la longueur du canal de conduction et la dimension du motif de partage. Dans ce cas de figure, le canal et le motif de partage 8 sont autoalignés avec le motif de grille 3. La formation des zones de source et de drain, par la suite, permet de former facilement un motif de partage encapsulé par des matériaux semiconducteurs.

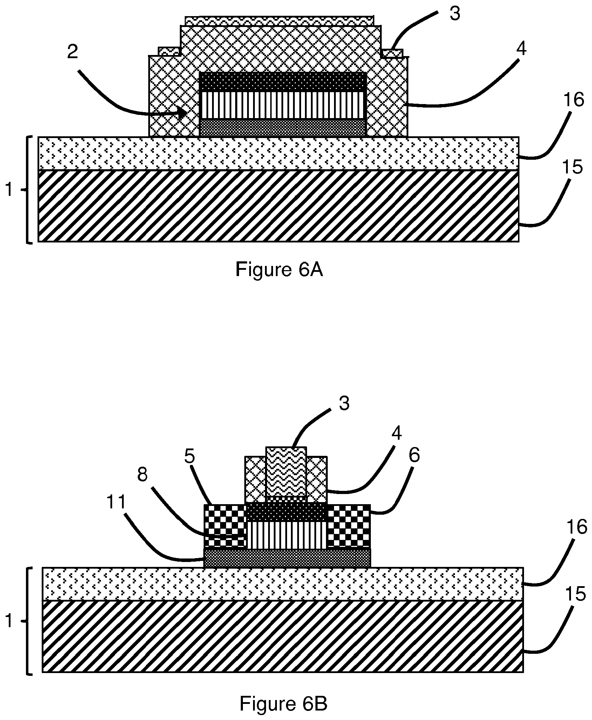

Comme illustré aux figures 6A et 6B, une épitaxie sélective est ensuite réalisée pour faire croitre un matériau semi-conducteur à partir de la première couche 9 et former les zones de source et de drain. Dans ce cas de figure, il est particulièrement avantageux d'utiliser la troisième couche 11 qui permet d'augmenter la surface disponible pour le démarrage de l'épitaxie. Le matériau semi-conducteur déposé va former les zones de source 5 et de drain 6.

Le document US2013/0299897 décrit la croissance d'une couche de silicium ou de silicium-germanium depuis le substrat de support et la couche de semi-conducteur sur isolant. Or, le substrat de support et la couche de semi-conducteur sur isolant ne sont pas alignés lors de la formation du substrat de type semi-conducteur sur isolant. Ce léger désalignement empêche une reprise d'épitaxie de très bonne qualité et des défauts cristallins peuvent se former dans les zones de source et de drain. En revanche, dans le procédé présenté plus haut, l'épitaxie est réalisée à partir de la couche 9 ou à partir des couches 9 et 11 qui étaient initialement en accord de maille. Cette précaution permet d'avoir une reprise d'épitaxie de meilleure qualité.

Pour former des transistors différents, il est également possible de prévoir, sur le substrat, des empilements différents, par exemple avec des épaisseurs différentes de la couche 10 ce qui n'est pas possible avec un substrat de type semi-conducteur sur isolant.

Le motif en matériau semi-conducteur 2 peut être dopé par implantation de dopants électriques dans les zones de source 5 et de drain 6. Si une épitaxie est réalisée, il est également envisageable de réaliser un dopage in-situ lors du dépôt du matériau semi-conducteur par épitaxie.

Lors de l'étape d'épitaxie sélective, il est possible de distinguer les transistors Nmos et les transistor Pmos en réalisant deux étapes différentes qui sont destinées à déposer deux matériaux différents. Pour les transistors Pmos, il est avantageux de déposer un alliage de silicium-germanium. Pour les transistors Nmos, il est avantageux de déposer du silicium.

L'utilisation d'un substrat de type semi-conducteur sur isolant tel que décrit dans le document US 2013/0299897 ne permet pas non plus de former des zones contraintes en tension et des zones contraintes en compression au moyen de la couche d'isolant enterré.

Dans un mode de réalisation avantageux non représenté, un deuxième espaceur latéral est formé en plus de l'espaceur latéral 4. Ce deuxième espaceur latéral vient recouvrir une partie des zones de source et de drain. Une implantation de dopants électriques est réalisée avec une dose plus importante de manière à former des zones de source/drain faiblement résistives. Le deuxième espaceur latéral permet de décaler les dopants par rapport au canal de conduction.

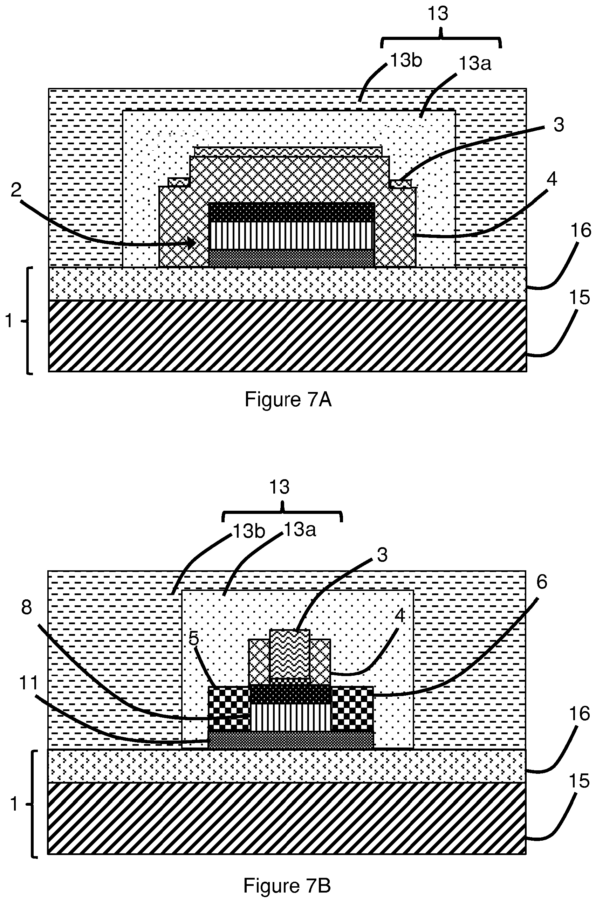

Comme illustré aux figures 7A et 7B, l'ensemble est ensuite recouvert par au moins une couche de couverture 13 électriquement isolante. Dans le mode de réalisation illustré, la couche de couverture comporte une première sous-couche de couverture 13a qui est en contact avec les zones de source/drain et le motif de grille 3. Une deuxième sous-couche de couverture 13b est déposée de manière à recouvrir la première sous-couche 13a et former une surface externe plus plane. De manière avantageuse, une étape d'aplanissement est réalisée pour former une surface supérieure plane. A titre d'exemple, l'aplanissement est réalisé par une étape de polissage mécano-chimique. La couche 13a peut être structurée avant le dépôt de la couche 13b ou être laissée inchangée.

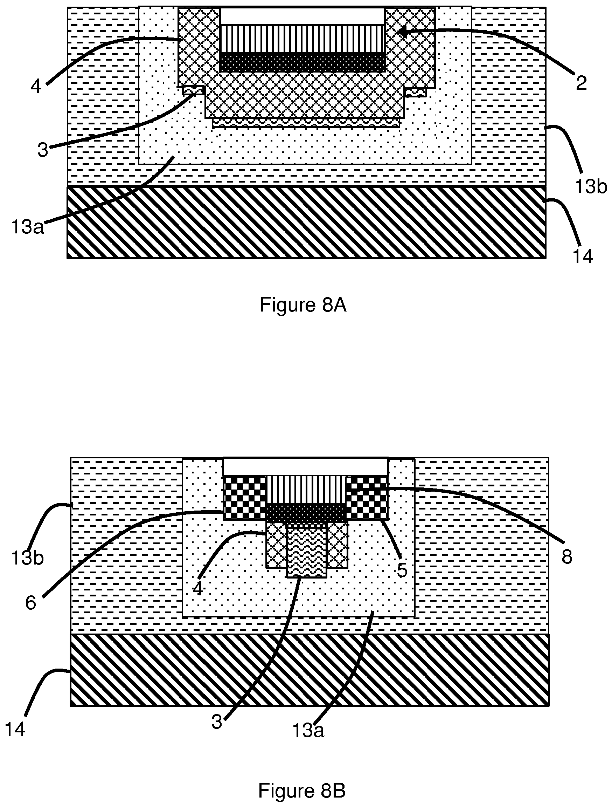

Comme illustré aux figures 8A et 8B, la face supérieure de la couche de couverture 13 est ensuite fixée à un second substrat 14 et le premier substrat 1 est éliminé de manière à accéder au motif de partage 8, aux zones de source 5 et de drain 6 et au motif de grille 3. De manière avantageuse, la face supérieure de la couche de couverture 13 est collée au second substrat 14. A titre d'exemple, le second substrat 14 est un substrat massif de silicium qui comporte avantageusement une couche d'oxyde de silicium en surface pour faciliter le collage de la couche de couverture 13. Dans le mode de réalisation illustré aux figures 8A et 8B, la couche 11 est complètement éliminée. En variante, il est possible de laisser la couche 11 sur les zones de source et de drain mais il est nécessaire de former un masque de gravure spécifique pour éviter un court-circuit entre les zones de source et de drain. La couche 11 peut être électriquement conductrice pour former par la suite les contacts de source et de drain. Il en est de même pour la quatrième couche 11' quand elle est utilisée.

Pour faciliter l'élimination du premier substrat 1, il est avantageux d'utiliser un substrat de type semi-conducteur sur isolant dans lequel la deuxième couche 10 ou la troisième couche 11 est formée par la couche active du substrat 1. Cette couche active est séparée du substrat de support 15 par la couche électriquement isolante 16. Le substrat de support 15 est éliminé pour accéder à la couche électriquement isolante 16. Ensuite, la couche électriquement isolante 16 est éliminée ce qui libère l'accès aux zones de source/drain, au motif de partage 8 et au motif de grille 3. Le substrat de support 15 en silicium peut être éliminé par une abrasion mécanique suivie d'une abrasion chimique avec une solution de TMAH. La couche électriquement isolante 16 peut être ensuite éliminée par une solution de type acide fluorhydrique. A titre d'exemple, une solution contenant entre 0,1% et 2% d'acide fluorhydrique permet d'avoir une sélectivité importante vis-à-vis des matériaux communément utilisés dans la formation d'un dispositif à effet de champ, par exemple le nitrure de silicium, un diélectrique de grille à plus forte permittivité.

En variante, il est également possible de prévoir un substrat 1 qui comporte une partie support 15 séparée de la deuxième ou de la troisième couche par un matériau différent 16 de manière à faciliter la gravure du support 15 avec la détection de la couche en matériau différent 16. La couche en matériau différent 16 est ensuite gravée sélectivement pour libérer l'accès aux zones recherchées. Le matériau différent 16 est par exemple une couche en alliage de silicium-germanium.

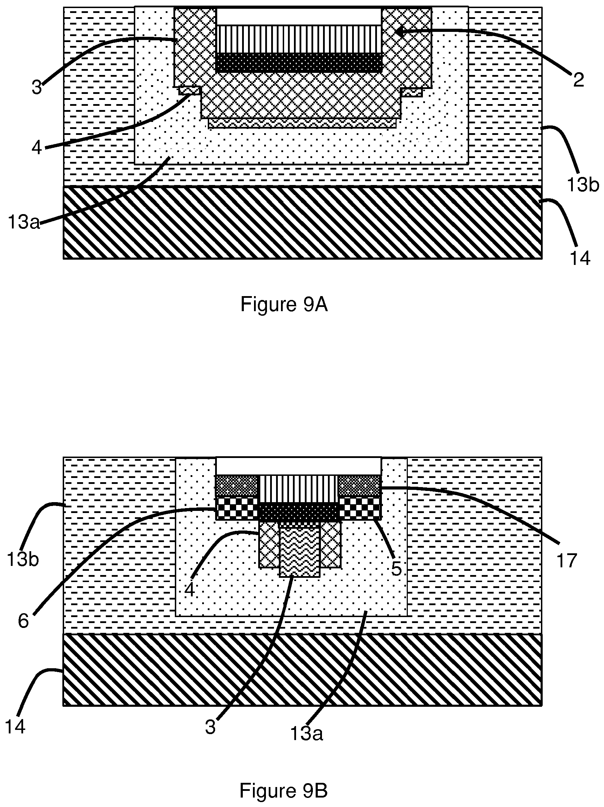

Comme illustré aux figures 9A et 9B, une fois l'accès aux zones de source/drain réalisé, le matériau semi-conducteur formant les zones de source/drain 5 et 6 réagit avec un métal pour former un alliage 17. Cet alliage 17 permet de réduire la résistance de contact des zones de source/drain 5 et 6. L'alliage 17 comporte au moins un matériau semi-conducteur provenant du motif 2, par exemple du silicium et/ou du germanium. L'alliage 17 comporte également le métal déposé par exemple du titane, du cobalt ou du nickel. L'alliage 17 peut être un siliciure.

Il est particulièrement avantageux de former l'alliage après le changement de support, par exemple après la formation de la couche de couverture 13 ou après l'élimination du substrat de support 15. En effet, lors du changement de couche assurant le support mécanique du futur transistor, il peut y avoir une étape de recuit afin d'assurer un bon collage par exemple entre la couche de couverture 13 et la couche 16. Ce budget thermique lié au collage peut détériorer partiellement l'alliage qui est alors moins performant électriquement.

Pour les mêmes raisons, il est également avantageux de réaliser l'alliage du motif de grille 3 après le budget thermique de collage ou au moins après le dépôt de la couche de couverture 13. Par ailleurs, si l'alliage est réalisé avant le retournement, pour accéder au motif de grille, il peut être nécessaire de traverser les régions source/drain. Dans ce cas de figure, la partie verticale du trou de contact peut être dépourvue d'alliage ce qui réduit le gain sur les performances électriques.

Si la couche 11 est utilisée, il peut être avantageux d'éliminer la couche 11 pour accéder aux zones de source et de drain et éviter dès à présent un court-circuit. De préférence, la couche 11 est éliminée avant de déposer un matériau métallique et de la faire réagir avec un matériau semi-conducteur car le retrait est plus compliqué.

Si un métal est déposé pour former un alliage dans les zones de source/drain 5 et 6, il est avantageux de prévoir un motif de partage 8 dans un matériau qui ne réagit pas avec le métal pour éviter de former un court-circuit entre les électrodes de source 5 et de drain 6. Le motif de partage 8 est électriquement isolant.

Un motif 8 en oxyde de silicium ou en nitrure de silicium est particulièrement avantageux car il évite la présence d'un court-circuit entre les zones de source 5 et de drain 6. En variante, il est possible de graver la zone en court-circuit mais cela impose une étape de photo-lithographie supplémentaire.

Si le motif de partage 8 est électriquement conducteur, il est éliminé au moins en partie pour éviter un court-circuit entre les zones de source 5 et de drain 6.

Le métal qui n'a pas réagi avec le matériau semi-conducteur pour former l'alliage 17 est éliminé.

En variante, une fois l'accès aux zones de source/drain réalisé, il est également possible de réaliser l'implantation de dopants électriques dans les zones de source 5 et de drain 6. Ce cas de figure est particulièrement avantageux, car le transistor est quasiment terminé et l'énergie d'implantation est minime. Le motif de partage 8 vient protéger le canal de conduction et une partie de l'électrode de grille 3. Il est possible de réaliser l'implantation avant de déposer le métal ou un autre matériau électriquement conducteur.

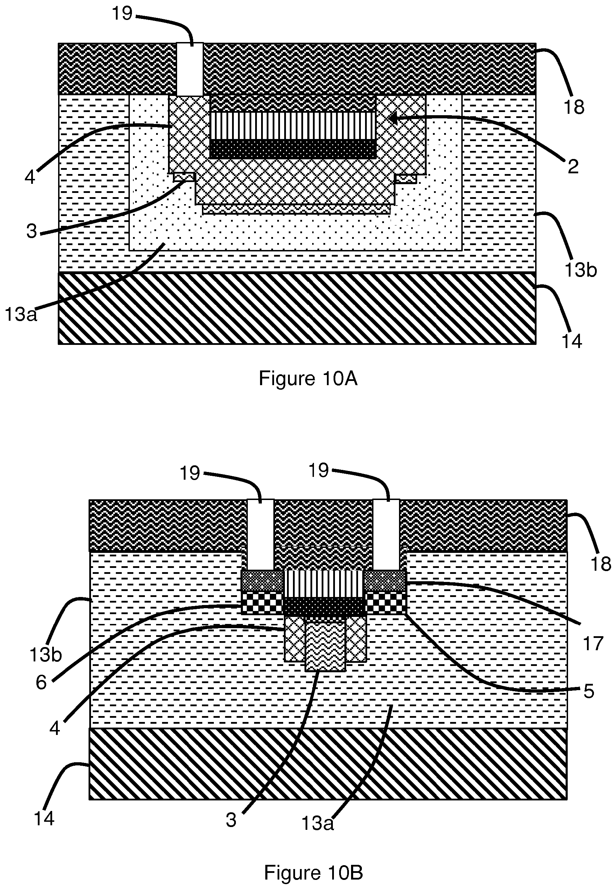

Comme illustré aux figures 10A et 10B, les zones de source/drain, le motif de grille 3 et le motif de partage 8 sont recouverts par une deuxième couche de couverture 18 électriquement isolante qui peut être identique à la première couche de couverture 13 ou différente.

Des trous de contact 19 sont formés dans la couche de couverture 18 pour venir accéder à la zone de source 5, à la zone de drain 6 et au motif de grille 3. Les trous de contacts sont remplis par un conducteur électrique, par exemple un métal pour connecter le dispositif à effet de champ.

Dans cette configuration, les contacts de source et de drain ne viennent pas à proximité de l'électrode grille 3 ce qui permet une plus grande souplesse dans le positionnement des contacts. Les capacités électriques entre l'électrode de grille 3 et les contacts de source/drain sont également fortement réduites. Les contacts de source 5 et de drain 6 sont disposés d'un côté du canal de conduction et l'électrode de grille est majoritairement disposée de l'autre coté du canal de conduction.

Le contact de grille est avantageusement déporté à l'extrémité du motif en matériau semi-conducteur 2, de préférence à l'extérieur du motif 2.

Dans un mode de réalisation particulier non représenté, la couche électriquement isolante 16 est conservée. Des trous sont formés pour accéder aux zones de source 5 et de drain 6. Il en est de même pour l'accès au motif de grille 3. Si une couche 11 est utilisée, les trous sont configurés pour empêcher un court-circuit entre les zones de source et de drain via la couche 11.

La deuxième couche de couverture 18 est déposée sur la couche électriquement isolante 16 et des trous d'accès sont formés. Une première série de trous peut être formée avant de déposer la deuxième couche de couverture 18 et une deuxième série de trous est formée après le dépôt de la couche de couverture 18. Il est également possible de former les trous uniquement après le dépôt de la deuxième couche de couverture 18.

Le motif de grille 3 peut être utilisé pour actionner le dispositif à effet de champ. Le motif de grille est alors une électrode de grille 3 qui comporte un matériau électriquement conducteur qui est séparé du canal de conduction par un matériau électriquement isolant également appelé diélectrique de grille 3a.

Dans un autre mode de réalisation, le motif de grille 3 est appelé « fausse grille » et il est retiré pour former une nouvelle cavité. Le volume de la nouvelle cavité délimitée par le motif en matériau semi-conducteur 2 et la couche 13 est ensuite rempli par un diélectrique de grille 3a et par un matériau électriquement conducteur qui va former le conducteur de grille.

Ce procédé est particulièrement avantageux pour former des transistors Nmos et Pmos car il est possible de réaliser facilement des zones avec des empilements différents.

## Revendications

1. Procédé de réalisation d'un dispositif à effet de champ comportant successivement :
- prévoir un substrat (1, 15, 16) recouvert par
∘ un motif en matériau semi-conducteur (2) comportant une première couche (9) en premier matériau semi-conducteur recouvrant une deuxième couche (10) en deuxième matériau semi-conducteur,
∘ un motif de grille (3) recouvrant le motif en matériau semi-conducteur (2) de manière à définir une zone de source (5), une zone de drain (6) et un canal de conduction dans le motif en matériau semi-conducteur (2),
- graver la première couche (9) en premier matériau semi-conducteur en utilisant le motif de grille (3) comme masque de gravure,
- graver la deuxième couche (10) en deuxième matériau semi-conducteur de manière à former une cavité et suspendre la première couche (9) en premier matériau semi-conducteur,
- déposer un matériau de remplissage (12) électriquement isolant de manière à remplir la cavité,
- graver le matériau de remplissage (12) en utilisant le motif de grille (3) comme masque de gravure pour former un motif de partage (8) dans la cavité, le motif en matériau semi-conducteur (2) recouvrant le motif de partage (8), le motif de partage (8) étant électriquement isolant et comportant au moins trois faces consécutives recouvertes par le motif en matériau semi-conducteur (2),
- former les zones de source (5) et de drain (6) par épitaxie sélective,
- déposer une couche de couverture (13a, 13b) de manière à recouvrir le substrat (1), le motif en matériau semi-conducteur (2) et le motif de grille (3),
- éliminer le substrat (1, 15, 16) de manière à libérer une partie de la zone de source (5), de la zone de drain (6) et du motif de grille (3),
- déposer un matériau métallique et le recuire pour former un alliage (17) par réaction entre le matériau métallique et un matériau semi-conducteur des zones de source et de drain,
- déposer une deuxième couche de couverture (18), les première et deuxième couches de couverture (13a, 13b, 18) étant séparées par le motif en matériau semi-conducteur (2) sur au moins une partie,
- former des trous d'accès (19, 22, 26) à la zone de source (5), à la zone de drain (6) et au motif de grille (3) dans la deuxième couche de couverture (18)
- remplir les trous d'accès (19, 22, 26) par un conducteur électrique de manière à former des contacts de source (5) et de drain (6) disposés d'un côté du canal de conduction et une électrode de grille majoritairement disposée de l'autre côté du canal de conduction.

2. Procédé selon la revendication 1, **caractérisé en ce que** le substrat comporte une troisième couche (11) en troisième matériau semi-conducteur différent du deuxième matériau semi-conducteur, la troisième couche (11) étant disposée sous la deuxième couche (10).

3. Procédé selon la revendication 2, **caractérisé en ce que** le premier matériau semi-conducteur est identique au troisième matériau semi-conducteur.

4. Procédé selon l'une des revendications 2 et 3, dans lequel les gravures de la deuxième couche (10) et du matériau de remplissage (12) sont configurées pour sauvegarder au moins une partie de la troisième couche (11) de manière à permettre la formation des zones de source (5) et de drain (6) depuis la troisième couche (11) lors de l'étape d'épitaxie sélective

5. Procédé selon l'une des revendications 2 à 4, **caractérisé en ce que** le motif de grille (3) est utilisé comme masque de gravure pour graver la première couche (9) et la deuxième couche (10) de sorte que la troisième couche (11) comporte une zone partiellement découverte par la deuxième couche (10) et **en ce que** les zones de source et de drain sont formées par épitaxie à partir de la zone partiellement découverte.

6. Procédé selon l'une des revendications 2 à 5, dans lequel la gravure du matériau de remplissage est réalisée en utilisant le motif de grille (3) en tant que masque de gravure de sorte que la troisième couche (11) soit partiellement recouverte par le matériau de remplissage (12) formant le motif de partage (8).

7. Procédé selon l'une quelconque des revendications 1 à 6, **caractérisé en ce que** le substrat est un substrat de type silicium sur isolant et **en ce qu'**il comporte une étape de condensation du germanium pour former la deuxième couche (10) ou une troisième couche (11) en alliage de silicium-germanium.

8. Procédé selon l'une des revendications 2 à 6, **caractérisé en ce qu'**il comporte une quatrième couche (11') en quatrième matériau semi-conducteur différent du troisième semi-conducteur, la quatrième couche (11') étant disposée sous la troisième couche (11').

9. Procédé selon la revendication 7, **caractérisé en ce que** le substrat est de type silicium sur isolant et **en ce que** la première couche (9) est en alliage de silicium-germanium.

## Patentansprüche

1. Verfahren zur Herstellung einer Feldeffektvorrichtung, umfassend die nachstehenden aufeinanderfolgenden Schritte:
- Bereitstellen eines Substrats (1, 15, 16), das bedeckt ist mit
∘ einem Halbleitermaterial-Muster (2), umfassend eine erste Schicht (9) aus einem ersten Halbleitermaterial, die eine zweite Schicht (10) aus einem zweiten Halbleitermaterial bedeckt,
∘ einem Gate-Muster (3), welches das Halbleitermaterial-Muster (2) bedeckt, um im Halbleitermaterial-Muster (2) einen Source-Bereich (5), einen Drain-Bereich (6) und einen Leitungskanal zu definieren,
- Ätzen der ersten Schicht (9) aus dem ersten Halbleitermaterial unter Verwendung des Gate-Musters (3) als Ätzmaske,
- Ätzen der zweiten Schicht (10) aus dem zweiten Halbleitermaterial, um einen Hohlraum zu bilden und die erste Schicht (9) aus dem ersten Halbleitermaterial aufzuhängen,
- Aufbringen eines elektrisch isolierenden Füllmaterials (12), um den Hohlraum zu füllen,
- Ätzen des Füllmaterials (12) unter Verwendung des Gate-Musters (3) als Ätzmaske, um im Hohlraum ein Teilungsmuster (8) zu bilden, wobei das Halbleitermaterial-Muster (2) das Teilungsmuster (8) bedeckt, das Teilungsmuster (8) elektrisch isolierend ist und mindestens drei aufeinanderfolgende Flächen aufweist, die vom Halbleitermaterial-Muster (2) bedeckt sind,
- Bilden der Source- (5) und Drain-Bereiche (6) durch selektive Epitaxie,
- Aufbringen einer Deckschicht (13a, 13b), um das Substrat (1), das Halbleitermaterial-Muster (2) und das Gate-Muster (3) zu bedecken,
- Entfernen des Substrats (1, 15, 16), um einen Teil des Source-Bereichs (5), des Drain-Bereichs (6) und des Gate-Musters (3) freizulegen,
- Aufbringen eines metallischen Materials und Glühen desselben, um durch Reaktion zwischen dem metallischen Material und einem Halbleitermaterial der Source- und Drain-Bereiche eine Legierung (17) zu bilden,
- Aufbringen einer zweiten Deckschicht (18), wobei die erste und die zweite Deckschicht (13a, 13b, 18) über mindestens einen Teil hinweg durch das Halbleitermaterial-Muster (2) getrennt sind,
- Bilden von Zugangslöchern (19, 22, 26) in der zweiten Deckschicht (18) zum Source-Bereich (5), zum Drain-Bereich (6) und zum Gate-Muster (3),
- Füllen der Zugangslöcher (19, 22, 26) mit einem elektrischen Leiter, um Source- (5) und Drain-Kontakte (6) zu bilden, die auf einer Seite des Leitungskanals angeordnet sind, und eine Gate-Elektrode, die hauptsächlich auf der anderen Seite des Leitungskanals angeordnet ist.

2. Verfahren nach Anspruch 1, **dadurch gekennzeichnet, dass** das Substrat eine dritte Schicht (11) aus einem dritten Halbleitermaterial umfasst, das sich vom zweiten Halbleitermaterial unterscheidet, wobei die dritte Schicht (11) unter der zweiten Schicht (10) angeordnet ist.

3. Verfahren nach Anspruch 2, **dadurch gekennzeichnet, dass** das erste Halbleitermaterial mit dem dritten Halbleitermaterial identisch ist.

4. Verfahren nach einem der Ansprüche 2 und 3, wobei das Ätzen der zweiten Schicht (10) und des Füllmaterials (12) dazu konfiguriert sind, mindestens einen Teil der dritten Schicht (11) zu wahren, um während des Schritts der selektiven Epitaxie die Bildung der Source- (5) und Drain-Bereiche (6) von der dritten Schicht (11) aus zu ermöglichen.

5. Verfahren nach einem der Ansprüche 2 bis 4, **dadurch gekennzeichnet, dass** das Gate-Muster (3) als Ätzmaske zum Ätzen der ersten Schicht (9) und der zweiten Schicht (10) verwendet wird, sodass die dritte Schicht (11) einen Bereich aufweist, der unter der zweiten Schicht (10) partiell freiliegt, und dadurch, dass die Source- und Drain-Bereiche vom partiell freiliegenden Bereich ausgehend durch Epitaxie gebildet werden.

6. Verfahren nach einem der Ansprüche 2 bis 5, wobei das Ätzen des Füllmaterials unter Verwendung des Gate-Musters (3) als Ätzmaske so durchgeführt wird, dass die dritte Schicht (11) vom Füllmaterial (12), welches das Teilungsmuster (8) bildet, partiell bedeckt wird.

7. Verfahren nach einem der Ansprüche 1 bis 6, **dadurch gekennzeichnet, dass** das Substrat ein Silizium-auf-Isolator-Substrat ist und dadurch, dass es einen Schritt der Kondensation des Germaniums umfasst, um die zweite Schicht (10) oder eine dritte Schicht (11) aus Silizium-Germanium-Legierung zu bilden.

8. Verfahren nach einem der Ansprüche 2 bis 6, **dadurch gekennzeichnet, dass** es eine vierte Schicht (11') aus einem vierten Halbleitermaterial umfasst, das sich vom dritten Halbleiter unterscheidet, wobei die vierte Schicht (11') unter der dritten Schicht (11') angeordnet ist.

9. Verfahren nach Anspruch 7, **dadurch gekennzeichnet, dass** das Substrat ein Silizium-auf-Isolator-Substrat ist, und dadurch, dass die erste Schicht (9) aus Silizium-Germanium-Legierung besteht.

## Claims

1. A fabrication method of a field effect device successively comprising:
- providing a substrate (1, 15, 16) covered by
∘ a pattern made from semiconductor material (2) comprising a first layer (9) made from a first semiconductor material covering a second layer (10) made from a second semiconductor material,
∘ a gate pattern (3) covering the pattern made from semiconductor material (2) so as to define a source region (5), a drain region (6) and a conduction channel in the pattern made from semiconductor material (2),
- etching the first layer (9) made from the first semiconductor material using the gate pattern (3) as etch mask,
- etching the second layer (10) made from a second semiconductor material so as to form a cavity and to suspend the first layer (9) made from the first semiconductor material,
- depositing a electrically insulating filling material (12) so as to fill the cavity,
- etching the filling material (12) using the gate pattern (3) as etch mask to form a dividing pattern (8) in the cavity, the pattern made from semiconductor material (2) covering the dividing pattern (8), the dividing pattern (8) being electrically insulating and comprising at least three consecutive surfaces covered by the pattern made from semiconductor material (2),
- forming the source (5) and drain (6) regions by selective epitaxy,
- depositing a covering layer (13a, 13b) so as to cover the substrate (1), the pattern made from semiconductor material (2) and the gate pattern (3),
- eliminating the substrate (1, 15, 16) so as to release a part of the source region (5), of the drain region (6) and of the gate pattern (3),
- depositing a metallic material and annealing it to form an alloy (17) by reaction between the metallic material and a semiconductor material of the source and drain regions,
- depositing a second covering layer (18), the first and second covering layers (13a, 13b, 18) being separated by the pattern made from semiconductor material (2) over at least a part thereof,
- forming access vias (19, 22, 26) to the source region (5), the drain region (6) and the gate pattern (3) in the second covering layer (18),
- filling the access vias (19, 22, 26) with an electrical conductor so as to form source (5) and drain (6) contacts arranged on one side of the conduction channel and a gate electrode predominantly arranged on the other side of the conduction channel.

2. The method according to claim 1, **characterized in that** the substrate comprises a third layer (11) made from third semiconductor material different from the second semiconductor material, the third layer (11) being arranged underneath the second layer.

3. The method according to claim 2, **characterized in that** the first semiconductor material is identical to the third semiconductor material.

4. The method according to any of claims 2 and 3, wherein the etches of the second layer (10) and of the filling material (12) are configured to preserve at least a part of the third layer (11) so as to enable formation of the source (5) and drain (6) regions from the third layer (11) when the selective epitaxy step is performed.

5. The method according to any of claims 2 to 4, **characterized in that** the gate pattern (3) is used as etch mask to etch the first layer (9) and the second layer (10) so that the third layer (11) comprises a region partially uncovered by the second layer (10) and **in that** the source and drain regions are formed by epitaxy from the partially uncovered region.

6. The method according to any of claims 2 to 5, wherein etching of the filling material is performed using the gate pattern (3) as etch mask so that the third layer (11) is partially covered by the filling material (12) forming the dividing pattern (8).

7. The method according to any of claims 1 to 6, **characterized in that** the substrate is a silicon-on-insulator substrate and **in that** it comprises a condensation step of the germanium to form the second layer (10) or a third layer (11) made from silicon-germanium alloy.

8. The method according to one of claims 2 to 6, **characterized in that** it comprises a fourth layer (11') made from a fourth semiconductor material different from the third semiconductor material, the fourth layer (11') being arranged underneath the third layer (11').

9. The method according to claim 7, **characterized in that** the substrate is of silicon-on-insulator type and **in that** the first layer (9) is made from silicon-germanium alloy.
